(19) Europäisches Patentamt / European Patent Office / Office européen des brevets

(11) **EP 1 499 010 B1**

(12) **EUROPEAN PATENT SPECIFICATION**

(45) Date of publication and mention
of the grant of the patent:
**25.09.2013   Bulletin 2013/39**

(51) Int Cl.:
*H03C 1/60* (2006.01)

(21) Application number: **04016453.5**

(22) Date of filing: **13.07.2004**

(54) **Frequency translator, and method**

Frequenzumsetzer und Verfahren dazu

Convertisseur de fréquence, et procédé

(84) Designated Contracting States:
**DE FR GB NL**

(30) Priority: **14.07.2003   US 486416 P**
**30.03.2004   KR 2004021466**

(43) Date of publication of application:
**19.01.2005   Bulletin 2005/03**

(73) Proprietors:
• **Samsung Electronics Co., Ltd.**
**Suwon-si, Gyeonggi-do, 443-742 (KR)**
• **Staccato Communications, Inc.**
**San Diego, CA 92121 (US)**

(72) Inventors:
• **Abdellaoui, Mohsen**
**San Diego**
**CA 92121 (US)**
• **Kim, Yong-suk**
**Seo-gu**
**Daejeon (KR)**
• **Kim, Wan-jin**
**Seodaemun-gu**
**Seoul (KR)**
• **Meacham, Dan**
**San Diego**
**CA 92121 (US)**
• **Lee, Woo-Kyung**
**249-204, Ssangyong Apartment**
**Suwon-si**
**Gyeonggi-do (KR)**

(74) Representative: **Grünecker, Kinkeldey,**
**Stockmair & Schwanhäusser**
**Leopoldstrasse 4**
**80802 München (DE)**

(56) References cited:
**EP-A- 0 801 465     US-A- 4 955 083**
**US-B1- 6 519 279**

**Description**

Field of The Invention

Systems, apparatuses, and methods consistent with the present invention generally relate to a communication system using a wide band, and more specifically, to an apparatus and a method for generating a radio signal used in a wide- band communication.

Description of The Related Art

] In general, a communication system transmits data to a reception side using a carrier frequency, which requires the generation of the carrier frequency. A local oscillator (LO) is utilized to generate a frequency for data transmission. The data is transmitted using a signal generated by the LO, or, a predetermined procedure is firstly performed when the signal generated by the LO is not a desired signal. The desired signal is generated by performing the predetermined procedure with respect to the signal generated by the LO using a specific signal. Hereinafter, a LO signal denotes the signal generated by the LO.

In a wireless system applying quadrature phase shifting keying (QPSK), a mixer mixes the LO signal and intermediate frequency (IF) signals having a phase difference of 90° with respect to the LO signal so as to generate two signals having 90° phase difference at the same time. In general, a single mixer mixes the LO signal and the IF signal to simultaneously output two signals. Specifically, based on the frequency of the LO signal, one signal having a frequency higher than that of the IF signal and the other signal having a frequency lower than that of the IF signal are output A filter is used to select one of the two output signals. An undesired frequency is removed generally using a band-pass filter to pass only the desired frequency.

However, as the frequency becomes higher, it is harder to implement a narrow- band filter. It is preferred not to use the narrow- band filter since the implementation of the narrow- band filter is hard on an integrated circuit. To overcome these shortcomings, a single sideband (SSB) system is used to selectively generate one desired signal alone. The SSB system is described in detail below.

By Fourier-transforming and frequency-analyzing a signal of which amplitude is modulated, the signal is shifted to frequencies above and below the carrier frequency (IF), to thus generate an upper sideband (USB) and a lower sideband (LSB) carrying the same information. A double sideband (DSB) transmission transmits both of the USB and the LSB, and the SSB transmission transmits only one sideband by removing unnecessary sidebands. Since audio or music does not have signal components in low frequency band, the SSB transmission alone is enough to communicate. Since the signal is transmitted to the reception side in one of the USE and the LSB, the scale of the reception side is reduced and the power consumption is lowered.

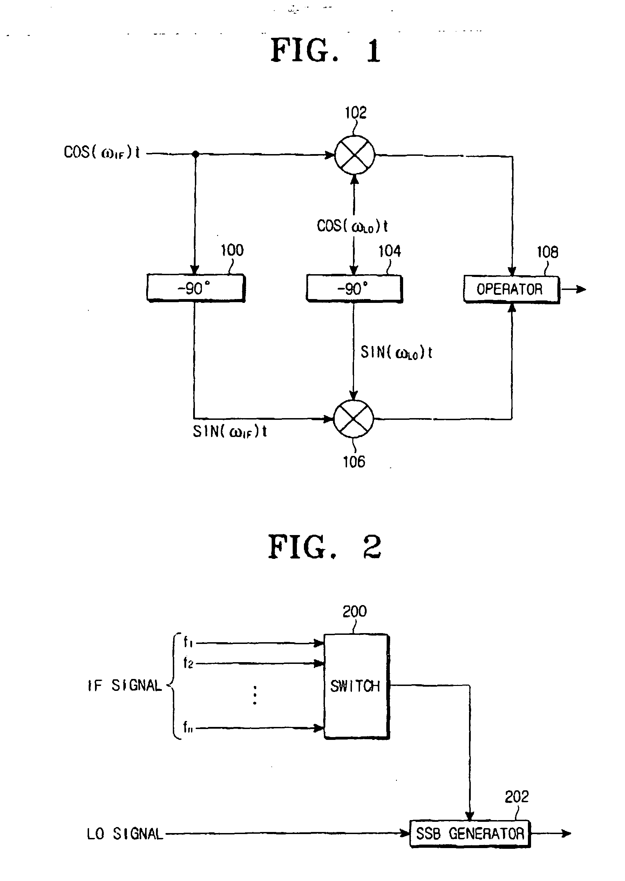

FIG. 1 illustrates a conventional SSB generator, which is described below. The SSB generator includes two mixers 102 and 106 and an operator 108.

The respective mixers 102 and 106 mix the input IF signal and LO signal. The mixed signals are furnished to the operator 108. The operator 108 performs an addition operation or a subtraction operation on the signals. The SSB generator outputs only one signal based on the following Equations.

Let the IF signal input to the mixer 102 be cos ($w_{IF}t$) and let the LO signal be cos ($w_{LO}t$) . The mixer 102 outputs cos ($w_{IF}t$) cos ($w_{LO}t$) by mixing the received signals based on Equation 1. Let the IF signal input to the mixer 106 be sin ($w_{IF}t$) and let the LO signal be sin ($w_{LO}t$) . The mixer 106 outputs sin ($w_{IF}t$) sin ($w_{LO}t$) by mixing the received signals based on Equation 2.

[Equation 1]

$$\cos(w_{LO}t)\cos(w_{IF}t) = \frac{1}{2}[\cos((w_{LO} + w_{IF})t) + \cos((w_{LO} - w_{IF})t)]$$

[Equation 2]

$$\sin(w_{LO}t)\sin(w_{IF}t) = \frac{1}{2}[-\cos((w_{LO} + w_{IF})t) + \cos((w_{LO} - w_{IF})t)]$$

Equation 1 represents the operations of the mixer 102, and Equation 2 represents the operations of the mixer 106.
The operator 108 performs the addition operation with respect to the signals received from the mixers 102 and 106. The following Equation 3 represents operations of the operator 108.

**[Equation 3]**

$$\frac{1}{2}[\cos((w_{LO} + w_{IF})t) + \cos((w_{LO} - w_{IF})t)] + \frac{1}{2}[-\cos((w_{LO} + w_{IF})t) + \cos((w_{LO} - w_{IF})t)]$$
$$= \cos((w_{LO} - w_{IF})t)$$

In Equation 3, the operator 108 generates the LSB signal.
Let the IF signal input to the mixer 102 be $sin\,(w_{IF}t)$ and let the LO signal be $\cos\,(w_{LO}t)$. The mixer 102 outputs $\sin\,(w_{IF}t)\cos\,(w_{LO}t)$ by mixing the received signals based on Equation 4. Let the IF signal input to the mixer 106 be $\cos\,(w_{IF}t)$ and let the LO signal be $\sin\,(w_{LO}t)$. The mixer 106 outputs $\cos\,(w_{IF}t)\sin\,(w_{LO}t)$ by mixing the received signals based on Equation 5.

**[Equation 4]**

$$\cos(w_{LO}t)\sin(w_{IF}t) = \frac{1}{2}[\sin((w_{LO} + w_{IF})t) - \sin((w_{LO} - w_{IF})t)]$$

**[Equation 5]**

$$\sin(w_{LO}t)\cos(w_{IF}t) = \frac{1}{2}[\sin((w_{LO} + w_{IF})t) + \sin((w_{LO} - w_{IF})t)]$$

Equation 4 represents the operations of the mixer 102, and Equation 5 represents the operations of the mixer 106.
The operator 108 performs the addition operation with respect to the signal received from the mixers 102 and 106. The following Equation 6 represents the operations of the operator 108.

**[Equation 6]**

$$\frac{1}{2}[\sin((w_{LO} + w_{IF})t) - \sin((w_{LO} - w_{IF})t)] + \frac{1}{2}[\sin((w_{LO} + w_{IF})t) + \sin((w_{LO} - w_{IF})t)]$$
$$= \sin((w_{LO} + w_{IF})t)$$

In Equation 6, the operator 108 generates the USB signal.
The wide-band communication system uses a plurality of carriers to increase the data transmission amount FIG. 2 illustrates a frequency generator in the communication system which transmits data using the plurality of carriers.
Referring to FIG. 2, one LO signal and a plurality of the IF signals are combined to generate the desired number of carriers. The number of the IF signals is n-ary.
The LO signal generated by the LO is provided to the SSB generator 202. The switch 200 receives the n-ary IF signals, selects one of the n-ary IF signals, and provides the selected signal to the SSB generator 202. The SSB generator 202 performs the same operations as in FIG. 1, to thus output a single signal.
As shown in FIG. 2, the signal provided to the SSB generator 202 is not preset, but is selected from the n-ary signals. The SSB generator 202 performs the phase shift on the received signals by a certain unit. Referring back to FIG.1, the SSB generator 202 shifts the phase of the received signal to 90°. If the number of the received signals is plural, it is hard to perform the phase shift on each signal.

In general, the SSB generator performs accurately the phase shift on one signal. Accordingly, upon receiving other signals, the SSB generator cannot accurately perform the phase shift. If the SSB generator is constructed to shift the phase with respect to $f_1$ alone, it is infeasible to accurately shift the phase with respect to input $f_n$. The inaccurate phase shift results in error components in the signal output from the SSB generator.

US-B1-6 519 279 discloses a transceiver circuitry, portable communication device and method for performing radio communication. There is provided a transceiver circuitry comprising a first portion having a first modulation means operating at a first order of modulation for transmitting and receiving voice signals and comprising a second portion having a second modulation means operating at a second order of modulation for transmitting and receiving digital signals at a higher data rate than is achieved by the first portion and comprises a data conversion means operable to convert from or into voice signals intended for processing by the first person into or from digital signals for processing by the second portion. A codec 20 processes the data signals input to it to generate output signals which correspond to the input signals but which include an amount of redundancy therein such that if some bits in the signal are lost, the receiver will usually be able to detect that there has been such a loss and may even be able to recover the lost bits. The coded speech signal output by the codec 20 is input to the multiplexing and interleaving means 30. The multiplexing and interleaving 30 receives a number of different signals simultaneously and multiplexes them. It also performs interleaving, e.g. dispatching bits of a block of data into groups of data, wherein each group of data being destined to be sent in its own respective burst.

It is the object of the present invention to provide an improved method and apparatus capable of performing an accurate phase shift with respect to an entire signal received by an SSB generator.

This object is solved by the subject matter of the independent claims.

Preferred embodiments are defined by the dependent claims.

Another exemplary aspect of the present invention is to provide an apparatus and a method capable of enhancing data transmission by performing an accurate phase shift with respect to an entire signal received from a SSB generator.

To achieve the above aspects and features of the present invention, a method for generating an intermediate frequency (IF) to be transferred to a single sideband (SSB) generator which generates carriers using one local oscillator (LO) signal and at least two IF signals that are received, the method includes generating a group signal including a non-phase-shifted signal and a phase-shined signal comprising a phase shift of a predetemiined value with respect to each IF, and selecting one of at least two group signals and transferring the selected group signal to the SSB generator.

An apparatus for generating an intermediate frequency (IF) to be transferred to a single sideband (SSB) generator which generates carriers using one local oscillator (LO) signal and at least two IF signals that are received, the apparatus includes at least two phase shifters generating a group signal including a non-phase-shifted signal and a phase-shifted signal comprising a phase shift of a predetermined value with respect to each IF, and a multiplexer selecting one of at least two group signals and transferring the selected group signal to the SSB generator.

## BRIEF DESCRIPTION OF THE DRAWING FIGURES

These and/or other aspects and advantages of the invention will become apparent and more readily appreciated from the following description of the embodiments, taken in conjunction with the accompanying drawing figures of which:

FIG. 1 is a diagram illustrating a conventional SSB modulation;

] FIG. 2 is a diagram illustrating the generation of the SSB in a mobile communication system using a plurality of carriers;

FIG. 3 is a diagram illustrating a mobile communication system using a plurality of carriers according to an embodiment of the present invention;

FIG. 4 is a diagram illustrating the mobile communication system using the plurality of carriers according to another embodiment of the present invention;

FIG. 5 is a diagram illustrating the multiplexer and the inverter according to an embodiment of the present invention; and

FIG. 6 is a flowchart illustrating exemplary operations of the multiplexer and the inverter according to an embodiment of the present invention.

## DETAILED DESCRIPTION OF THE EMBODIMENTS

Reference will now be made in detail to the embodiments of the present invention, examples of which are illustrated in the accompanying drawing figures, wherein like reference numerals refer to the like elements throughout The embodiments are described below in order to explain the present invention by referring to the drawing figures.

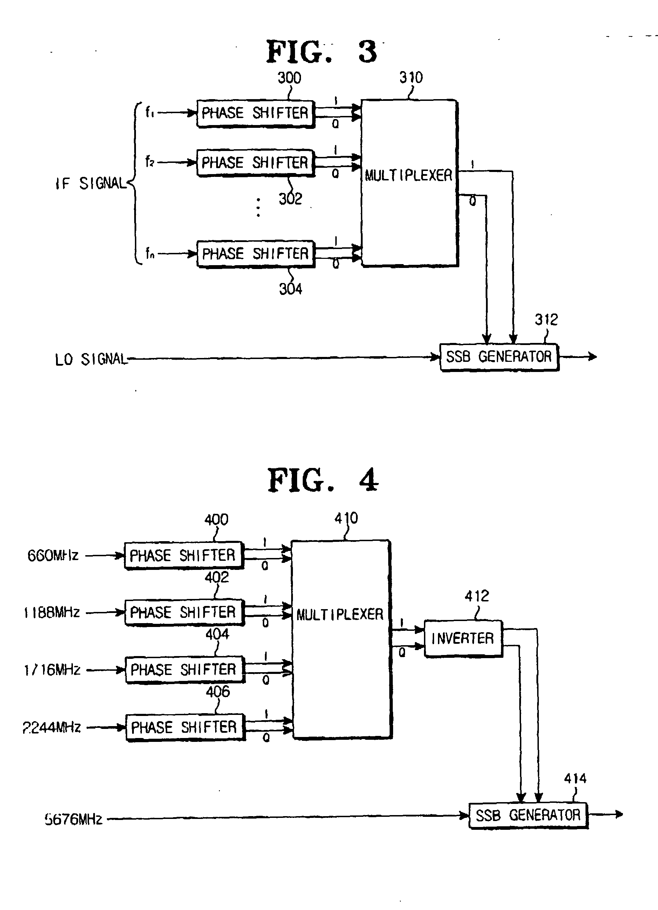

A method according to an embodiment of the present invention, transfers an intermediate frequency (IF) signal, whose phase is shifted, to a single sideband (SSB) generator, which is described in great detail below. FIG. 3 illustrates a frequency generator which generates a plurality of carriers according to an embodiment of the present invention.

Referring to FIG. 3, the frequency generator includes a plurality of phase shifters 300 to 304, a multiplexer 310, and a SSB generator 312. The phase shifters 300, 302 and 304 simultaneously output a phase-shifted signal and a non-phase-shifted signal. Hereinafter, the signals transferred from each of the phase shifters 300 to 304 are referred to as a group signal. The group signals generated in the phase shifters 300, 302 and 304 are transferred to the multiplexer 310. The multiplexer 310 transfers to the SSB generator 312 desired signals among the received signals. The signals transferred from the multiplexer 310 are a phase-shifted signal and a non-phase-shined signal with respect to one signal. A switch, as the multiplexer 310, may be utilized to select the signal to be transferred to the SSB generator 312. The SSB generator 312 generates a single signal using the signals received from the multiplexer 310 and a local oscillator (LO) signal, and outputs the generated signal. The SSB generator 312 performs the phase shift only on the LO signal and not on the signals transferred form the multiplexer 310, thus enhancing the efficiency of the SSB generator 312.

By way of example, it is assumed that signals (carriers) to be generated in the SSB generator 312 are at frequencies of about 3432 MHz, 3960 MHz, 4488 MHz, 6336 MHz, 6864 MHz, 7392 MHz, and 7920 MHz. To generate these signals, one LO signal and a plurality of the IF signals are generated. According to an embodiment of the present invention, the LO signal is at a frequency of about 5676 MHz, and the IF signals are combinations of frequencies of about 528 MHz and 660 MHz. The SSB generator 312 can generate signals using the LO signal and the IF signals as shown in Table 1.

[Table 1]

| LO signal | IF signal (660 MHz) | IF signal (528 MHz) | output signals of the SSB generator |
|---|---|---|---|
| 5676 MHz | 660 MHz | 3×528MHz | 7920 MHz |
| | 660 MHz | 2×528 MHz | 7392 MHz |
| | 660 MHz | 528 MHz | 6864 MHz |
| | 660 MHz | 0 | 6336 MHz |
| | -660 MHz | 0 | |
| | -660 MHz | -528 MHz | 4488 MHz |
| | -660 MHz | -2×528 MHz | 3960 MHz |
| | -660 MHz | -3×528 MHz | 3432 MHz |

FIG. 4 illustrates the frequency generator using the plurality of carriers according to another embodiment of the present invention. Referring to FIG. 4, signals transferred to the phase shiners 400, 402, 404 and 406 are frequencies of about 660 MHz, 1188 MHz, 1716 MHz, and 2244 MHz, respectively. These signals can be generated by combining the frequency signals of about 660 MHz and 528 MHz of Table 1. That is, the frequency signal of about 1188 MHz is generated by combining frequency signals of about 660 MHz and 528 MHz, and the frequency signal of about 2244 MHz is generated by combining fiequency signals of about 660 MHz and 3×528 MHz.

Each phase shifter 400, 402, 404 and 406 generates a phase-shifted signal and a non-phase-shifted signal with respect to the received signal, and transfers the generated signals to the multiplexer 410. The multiplexer 410 selects desired signals among the received signals and transfers the selected signals to an inverter 412. The signals selected by the multiplexer 410 are a phase-shifted signal and a non-phase-shifted signal with respect to one signal.

The inverter 412 determines whether to invert the received signals. If so, the inverter 412 inverts the received signals and transfers the inverted signals to the SSB generator 414. If not, the inverter 412 transfers the received signals to the SSB generator 414. Since the signals are passed through the multiplexer 410 and the inverter 412, the number of the signals to be input to the SSB generator 414 is eight One signal includes the phase-shifted signal and the non-phase-shifted signal.

The signals to be input to the SSB generator 414 are at frequencies of about -660 MHz, -1188 MHz, -1716 MHz, -2244 MHz, 660 MHz, 1188 MHz, 1716 MHz, and 2244 MHz. The SSB generator 414 generates and outputs a single signal using a frequency of about 5676 MHz and the signals received from the inverter 412. As mentioned above, the SSB generator 414 performs the phase shift only on the signal at a frequency of about 5676 MHz and not on the signals received from the inverter 412.

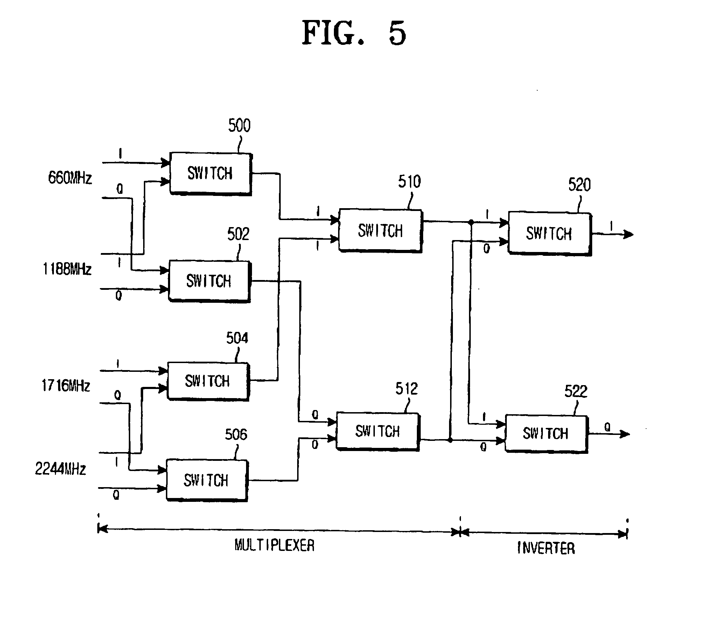

FIG. 5 illustrates structures of the multiplexer 410 and the inverter 412, which are described in detail below.

Let the phase-shifted signal be an I signal and the non-phase-shifted signal be a Q signal. The I signal of about 660 MHz output from the phase shifter 400 is transferred to the switch 500, and the Q signal of about 660 MHz is transferred to the switch 502. The I signal of about 1188 MHz output from the phase shifter 402 is transferred to the switch 500, and the Q signal of about 1188 MHz is transferred to the switch 502. The I signal of about 1716 MHz output from the phase shifter 404 is transferred to the switch 504, and the Q signal of about 1716 MHz is transferred to the switch 506. The I signal of about 2244 MHz output from the phase shifter 406 is transferred to the switch 504, and the Q signal of about 2244 MHz is transferred to the switch 506.

The switches 500 to 506 select signals to be transferred to the SSB generator 414 and transfer the selected signals to the switches 510 and 512. Specifically, one signal is selected from the two signals inputted into the switch 500, the other signal is selected from the two signals inputted into the switch 504, and the two selected signals are transferred to the switch 510. One signal is selected from the two signals inputted into the switch 502, the other signal is selected from the two signals inputted into the switch 506, and the two selected signals are transferred to the switch 512. In general, the switch 510 receives only one signal to be transferred to the SSB generator 414 at a certain time, but may receive two signals including the signal to be transferred. The switch 512 receives the signals having the same frequencies as the signals which are transferred to the switch 510.

The switch 510 outputs a signal to be transferred to the SSB generator 414 among the received signals. The switch 512 also outputs a signal to be transferred to the SSB generator 414 among the received signals. The output signal of the switch 510 is transferred to the switch 520 or the switch 522, and that of the switch 512 is transferred to the switch 520 or the switch 522.

The switch 520 or the switch 522 determines whether to invert the received signal. If not, the switch 520 outputs the I signal among the received signals, and the switch 522 outputs the Q signal among the received signals. If the received signals are inverted, the switch 520 outputs the Q signal among the received signal, and the switch 522 outputs the I signal among the received signals.

The output signals of the switches 520 and 522 are transferred to the SSB generator 414. The output signal of the switch 520 is mixed with the I signal of about 5676 MHz in the SSB generator 414, and that of the switch 522 is mixed with the Q signal of about 5676 MHz in the SSB generator 414.

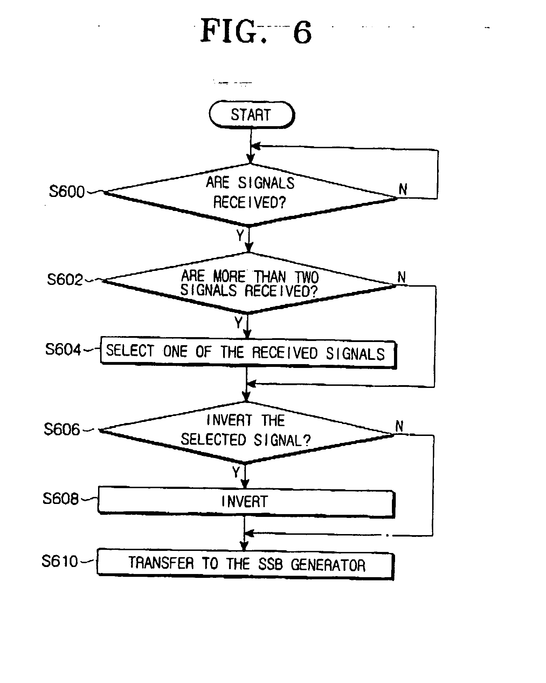

FIG. 6 illustrates exemplary operations of the multiplexer and the inverter according to an embodiment of the present invention, which are described in detail below.

The multiplexer determines whether the signals are received at step S600. If not, the multiplexer performs the step S600. If so, the multiplexer determines whether the number of the received signals is equal to or more than two at step S602. If more than two signals are received, the multiplexer selects one of the received signals at step S604. If not, that is, if one signal is received, the inverter determines whether to invert the received signal at stop S606.

If so, the inverter inverts the selected signal at step S608 and transfers the inverted signal to the SSB generator at step S610. If not, the inverter transfers the non-inverted signal to the SSB generator. Accordingly, the phase-shifted signal and the non-phase-shifted signal are generated from the single signal.

In the light of the foregoing, the phase-shifted signal is transferred to the SSB generator according to an embodiment of the present invention. Thus, it is feasible to implement the SSB generator which is available in the wide band by combining the narrow-band devices. In addition, the phase shifting is efficiently performer without having to use the phase shifter for the wide band signals.

While the embodiments of the present invention have been described, additional variations and modifications of the embodiments may occur to those skilled in the art once they learn of the basic inventive concepts. Therefore, it is intended that the appended claims shall be construed to include both the above embodiments and all such variations and modifications that fall within the scope of the invention.

**Claims**

1. A method for generating an intermediate frequency, IF, to be transferred to a single sideband, SSB, generator (312; 414) which generates carriers using one local oscillator (LO) signal and at least two IF signals, wherein the one LO signal and the at least two IF signals are received by said SSB generator (312; 414), the method comprising:

   generating by at least two phase shifters (300-304; 400-406) a group signal including a non-phase-shifted signal and a phase-shifted signal comprising a phase shift of a predetermined value with respect to each IF; and selecting by a multiplexer (310; 410) one of at least two group signals as a selected group signal and transferring the selected group signal to the SSB generator.

2. The method of claim 1, wherein the one received LO signal comprises a frequency of about 5676 MHz.

3. The method of claim 1, wherein each of the at least two IF signals are at a frequency of about 660 MHz, 1188 MHz, 1716 MHz, or 2244 MHz.

4. The method of claim 3, wherein the frequencies of about 1188 MHz, 1716 MHz, and 2244 MHz are generated by combining frequencies of about 660 MHz and of about 528 MHz or a multiple of the frequency of about 528 MHz.

5. The method of claim 1, wherein each of the carriers generated in the SSB generator (312; 414) are at a frequency of about 3432 MHz, 3960 MHz, 4488 MHz, 6336 MHz, 6864 MHz, 7392 MHz, or 7920 MHz.

6. The method of claim 5, wherein group signals corresponding to frequencies of about 1188 MHz, 1716 MHz, and 2244 MHz are inverted to generate the carriers of about 3432 MHz, 3960 MHz, and 4488 MHz, as inverted group signals, and the inverted group signals are transferred to the SSB generator.

7. The method of claim 1, wherein the predetermined value of the phase shift is about 90°.

8. An apparatus for generating an intermediate frequency, IF, to be transferred to a single sideband, SSB, generator (312; 414) which generates carriers using one local oscillator (LO) signal and at least two IF signals, wherein the one LO signal and the at least two IF signals are received by said SSB generator (312; 414), the apparatus comprising:

at least two phase shifters (300-304: 400-408) generating a group signal including a non-phase-shifted signal and a phase-shifted signal comprising a phase shift of a predetermined value with respect to each IF; and a multiplexer (310; 410) selecting one of at least two group signals as a selected group signal and transferring the selected group signal to the SSB generator (312; 414).

9. The apparatus of claim 8, wherein the SSB generator (312; 414) receives the one LO signal comprising a frequency of about 5676 MHz.

10. The apparatus of claim 9, wherein the SSB generator (312; 414) generates a non-phase-shifted signal of the one LO signal and a phase-shifted signal of the one LO signal comprising a phase shift of a predetermined degree.

11. The apparatus of claim 9, wherein the at least two phase shifters (300-304; 400-406) receive one of the at least two IF signals having frequencies of about 660 MHz, 1188 MHz, 1716 MHz, or 2244 MHz.

12. The apparatus of claim 11, wherein the frequencies of about 1188 MHz, 1716 MHz, and 2244 MHz are generated by combining frequencies of about 660 MHz and of about 528 MHz or a multiple of the frequency of about 528 MHz.

13. The apparatus of claim 8, wherein the SSB generator generates the carriers having frequencies of about 3432 MHz, 3960 MHz, 4488 MHz, 6336 MHz, 7392 MHz, or 7920 MHz.

14. The apparatus of claim 13, further comprising an inverter (412) inverting group signals corresponding to frequencies of about 1188 MHz, 1716 MHz, and 2244 MHz to generate the carriers comprising the frequencies of about 3432 MHz, 3960 MHz, or 4488 MHz, to generate inverted group signals, and the inverter transferring the inverted group signals to the SSB generator (312; 414).

**Patentansprüche**

1. Verfahren zum Erzeugen einer Zwischenfrequenz (Intermediate Frequency) IF zur Übertragung an einen SSB-Generator (Single Sideband SSB, Einzelseitenband) (312; 414), der Träger unter Verwendung eines LO-Signals (Local Oscillator LO, lokaler Oszillator) und wenigstens zweier IF-Signale erzeugt, wobei das eine LO-Signal und die wenigstens zwei IF-Signale von dem SSB-Generator (312; 414) empfangen werden, wobei das Verfahren umfasst:

durch wenigstens zwei Phasenverschieber (300 bis 304; 400 bis 406) erfolgendes Erzeugen eines Gruppensignals, das ein nichtphasenverschobenes Signal und ein phasenverschobenes Signal, das eine Phasenverschiebung eines vorbestimmten Wertes in Bezug auf jede Zwischenfrequenz IF umfasst, beinhaltet; und durch einen Multiplexer (310; 410) erfolgendes Auswählen eines von wenigstens zwei Gruppensignalen als ausgewähltes Gruppensignal und Übertragen des ausgewählten Gruppensignals an den SSB-Generator.

2. Verfahren nach Anspruch 1, wobei das eine empfangene LO-Signal eine Frequenz von etwa 5676 MHz umfasst.

**3.** Verfahren nach Anspruch 1, wobei jedes der wenigstens zwei IF-Signale bei einer Frequenz von etwa 660 MHz, 1188 MHz, 1716 MHz oder 2244 MHz ist.

**4.** Verfahren nach Anspruch 3, wobei die Frequenzen von etwa 1188 MHz, 1716 MHz und 2244 MHz durch Kombinieren von Frequenzen von etwa 660 MHz und von etwa 528 MHz oder eines Vielfachen der Frequenz von etwa 528 MHz erzeugt werden.

**5.** Verfahren nach Anspruch 1, wobei jeder der in dem SSB-Generator (312; 414) erzeugten Träger bei einer Frequenz von etwa 3432 MHz, 3960 MHz, 4488 MHz, 6336 MHz, 6864 MHz, 7392 MHz oder 7920 MHz ist.

**6.** Verfahren nach Anspruch 5, wobei Gruppensignale, die Frequenzen von etwa 1188 MHz, 1716 MHz und 2244 MHz entsprechen, zur Erzeugung der Träger von etwa 3432 MHz, 3960 MHz und 4488 MHz als invertierte Gruppensignale invertiert werden, und die invertierten Gruppensignale an den SSB-Generator übertragen werden.

**7.** Verfahren nach Anspruch 1, wobei der vorbestimmte Wert der Phasenverschiebung gleich etwa 90° ist.

**8.** Vorrichtung zum Erzeugen einer Zwischenfrequenz (Intermediate Frequency) IF zur Übertragung an einen SSB-Generator (Single Sideband SSB, Einzelseitenband) (312; 414), der Träger unter Verwendung eines LO-Signals (Local Oscillator LO, lokaler Oszillator) und wenigstens zweier IF-Signale erzeugt, wobei das eine LO-Signal und die wenigstens zwei IF-Signale von dem SSB-Generator (312; 414) empfangen werden, wobei die Vorrichtung umfasst:

wenigstens zwei Phasenverschieber (300 bis 304; 400 bis 408), die ein Gruppensignal erzeugen, das ein nichtphasenverschobenes Signal und ein phasenverschobenes Signal, das eine Phasenverschiebung eines vorbestimmten Wertes in Bezug auf jede Zwischenfrequenz IF umfasst, beinhaltet; und einen Multiplexer (310; 410), der eines von wenigstens zwei Gruppensignalen als ausgewähltes Gruppensignal auswählt und das ausgewählte Gruppensignal an den SSB-Generator (312; 414) überträgt.

**9.** Verfahren nach Anspruch 8, wobei der SSB-Generator (312; 414) das eine LO-Signal, das eine Frequenz von etwa 5676 MHz umfasst, empfängt.

**10.** Vorrichtung nach Anspruch 9, wobei der SSB-Generator (312; 414) ein nichtphasenverschobenes Signal des einen LO-Signals und ein phasenverschobenes Signal des anderen LO-Signals, das eine Phasenverschiebung eines vorbestimmten Grades umfasst, erzeugt.

**11.** Vorrichtung nach Anspruch 9, wobei die wenigstens zwei Phasenverschieber (300 bis 304; 400 bis 406) eines der wenigstens zwei IF-Signale mit Frequenzen von etwa 660 MHz, 1188 MHz, 1716 MHz oder 2244 MHz empfangen.

**12.** Verfahren nach Anspruch 11, wobei die Frequenzen von etwa 1188 MHz, 1716 MHz und 2244 MHz durch Kombinieren von Frequenzen von etwa 660 MHz und von etwa 528 MHz oder eines Vielfachen der Frequenz von etwa 528 MHz erzeugt werden.

**13.** Vorrichtung nach Anspruch 8, wobei der SSB-Generator die Träger mit Frequenzen von etwa 3432 MHz, 3960 MHz, 4488 MHz, 6336 MHz, 7392 MHz oder 7920 MHz erzeugt.

**14.** Verfahren nach Anspruch 13, des Weiteren umfassend einen Inverter (412), der Gruppensignale invertiert, die Frequenzen von etwa 1188 MHz, 1716 MHz und 2244 MHz entsprechen, um die Träger zu erzeugen, die die Frequenzen von etwa 3432 MHz, 3960 MHz oder 4488 MHz umfassen, um invertierte Gruppensignale zu erzeugen, wobei der Inverter die invertierten Gruppensignale an den SSB-Generator (312; 414) überträgt.

**Revendications**

**1.** Procédé permettant de générer une fréquence intermédiaire, IF, destinée à être transférée à un générateur de bande latérale unique, SSB, (312; 414) qui génère des porteuses en utilisant un signal d'oscillateur local (LO) et au moins deux signaux d'IF, dans lequel le signal de LO et les au moins deux signaux d'IF sont reçus par ledit générateur SSB (312; 314), le procédé comprenant :

la génération par au moins deux déphaseurs (300 à 304 ; 400 à 406) d'un signal de groupe incluant un signal non déphasé et un signal déphasé ayant un déphasage d'une valeur prédéterminée par rapport à chaque IF ; et la sélection par un multiplexeur (310 ; 410) d'un signal parmi au moins deux signaux de groupe en tant que signal de groupe sélectionné et le transfert du signal de groupe sélectionné au générateur SSB.

2. Procédé selon la revendication 1, dans lequel le signal de LO reçu possède une fréquence d'environ 5676 MHz.

3. Procédé selon la revendication 1, dans lequel chacun des au moins deux signaux d'IF possède une fréquence d'environ 660 MHz, 1188 MHz, 1716 MHz ou 2244 MHz.

4. Procédé selon la revendication 3, dans lequel les fréquences d'environ 1188 MHz, 1716 MHz et 2244 MHz sont générées en combinant des fréquences d'environ 660 MHz et d'environ 528 MHz ou un multiple de la fréquence d'environ 528 MHz.

5. Procédé selon la revendication 1, dans lequel chacune des porteuses générées dans le générateur SSB (312 ; 414) possède une fréquence d'environ 3432 MHz, 3960 MHz, 4488 MHz, 6336 MHz, 6864 MHz, 7392 MHz ou 7920 MHz.

6. Procédé selon la revendication 5, dans lequel les signaux de groupe correspondant aux fréquences d'environ 1188 MHz, 1716 MHz et 2244 MHz sont inversés afin de générer les porteuses d'environ 3432 MHz, 3960 MHz et 4488 MHz, en tant que signaux de groupe inversés et les signaux de groupe inversés sont transférés au générateur SSB.

7. Procédé selon la revendication 1, dans lequel la valeur prédéterminée du déphasage est d'environ 90°.

8. Dispositif permettant de générer une fréquence intermédiaire, IF, destiné à être transféré à un générateur de bande latérale unique, SSB, (312 ; 414) qui génère des porteuses en utilisant un signal d'oscillateur local (LO) et au moins deux signaux d'IF, dans lequel le signal de LO et les au moins deux signaux d'IF sont reçus par ledit générateur SSB (312 ; 414), le dispositif comprenant :

au moins deux déphaseurs (300 à 304 ; 400 à 408) générant un signal de groupe incluant un signal non déphasé et un signal déphasé ayant un déphasage d'une valeur prédéterminée par rapport à chaque IF ; et un multiplexeur (310 ; 410) sélectionnant un signal parmi au moins deux signaux de groupe en tant que signal de groupe sélectionné et transférant le signal de groupe sélectionné au générateur SSB (312 ; 414).

9. Dispositif selon la revendication 8, dans lequel le générateur SSB (312 ; 414) reçoit le signal de LO possédant une fréquence d'environ 5676 MHz.

10. Dispositif selon la revendication 9, dans lequel le générateur SSB (312 ; 414) génère un signal non déphasé du signal du LO et un signal déphasé du signal du LO ayant un déphasage d'un degré prédéterminé.

11. Dispositif selon la revendication 9, dans lequel les au moins deux déphaseurs (300 à 304 ; 400 à 406) reçoivent l'un des au moins deux signaux d'IF possédant des fréquences d'environ 660 MHz, 1188 MHz, 1716 MHz ou 2244 MHz.

12. Dispositif selon la revendication 11, dans lequel les fréquences d'environ 1188 MHz, 1716 MHz et 2244 MHz sont générées en combinant des fréquences d'environ 660 MHz et d'environ 528 MHz ou un multiple de la fréquence d'environ 528 MHz.

13. Dispositif selon la revendication 8, dans lequel le générateur SSB génère les porteuses possédant des fréquences d'environ 3432 MHz, 3960 MHz, 4488 MHz, 6336 MHz, 7392 MHz ou 7920 MHz.

14. Dispositif selon la revendication 13, comprenant en outre un inverseur (412) inversant les signaux de groupe correspondant aux fréquences d'environ 1188 MHz, 1716 MHz et 2244 MHz afin de générer les porteuses possédant les fréquences d'environ 3432 MHz, 3960 MHz ou 4488 MHz, pour générer des signaux de groupe inversés et l'inverseur transférant les signaux de groupe inversés au générateur SSB (312 ; 414).

# FIG. 1

$COS(\omega_{IF})t$

102

$\otimes$

$COS(\omega_{LO})t$

100

104

108

-90°

-90°

OPERATOR

$SIN(\omega_{LO})t$

$SIN(\omega_{IF})t$

$\otimes$

106

# FIG. 2

200

$f_1$

$f_2$

IF SIGNAL

SWITCH

$f_n$

202

LO SIGNAL

SSB GENERATOR

# FIG. 3

# FIG. 4

# FIG. 5

# FIG. 6

```
                    ┌─────────┐
                    │  START  │
                    └─────────┘
                         │
                         │    ◄─────────────────┐
                         ▼                      │
                    ╱ ARE SIGNALS ╲      N      │
      S600 ───────◄   RECEIVED?    ►────────────┘
                    ╲             ╱
                         │
                         │ Y
                         ▼
                    ╱ ARE MORE THAN TWO ╲   N
      S602 ───────◄  SIGNALS RECEIVED?   ►──────┐
                    ╲                   ╱        │
                         │                       │
                         │ Y                     │
                         ▼                       │
      S604 ─── ┌───────────────────────────────┐ │
               │ SELECT ONE OF THE RECEIVED SIGNALS │
               └───────────────────────────────┘ │
                         │                       │
                         ▼    ◄──────────────────┘
                    ╱ INVERT THE ╲      N
      S606 ───────◄ SELECTED SIGNAL? ►───────────┐
                    ╲             ╱               │
                         │                        │
                         │ Y                      │
                         ▼                        │
      S608 ─── ┌───────────────────────────────┐  │
               │            INVERT             │  │
               └───────────────────────────────┘  │
                         │    ◄──────────────────┘
                         ▼
      S610 ─── ┌───────────────────────────────┐
               │  TRANSFER TO THE SSB GENERATOR │
               └───────────────────────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6519279 B1